(19) **Europäisches Patentamt / European Patent Office / Office européen des brevets**

(11) **EP 2 590 190 B1**

(12) **EUROPEAN PATENT SPECIFICATION**

(45) Date of publication and mention of the grant of the patent:
**20.10.2021 Bulletin 2021/42**

(51) Int Cl.:
*H01G 4/012* (2006.01)    *H01G 4/33* (2006.01)
*H01G 4/38* (2006.01)    *H01G 7/06* (2006.01)
*H01L 23/522* (2006.01)

(21) Application number: **12191338.8**

(22) Date of filing: **05.11.2012**

(54) **Thin film capacitors**

Dünnfilmkondensatoren

Condensateurs à film mince

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **04.11.2011 US 201113289194**

(43) Date of publication of application:
**08.05.2013 Bulletin 2013/19**

(73) Proprietor: **NXP USA, Inc.**
**Austin TX 78735 (US)**

(72) Inventors:
• **Oakes, James**
**Nashua, NH New Hampshire 03060 (US)**
• **Martin, James**
**Londonderry, NH New Hampshire 03053 (US)**
• **Horne, Edward, Provo, Wallis**
**Burlington, Ontario L7R 1E1 (CA)**
• **McKinzie, William, E.**
**Fulton, MD Maryland 20759 (US)**

(74) Representative: **Miles, John Richard**
**NXP SEMICONDUCTORS**
**Intellectual Property Group**
**Abbey House**
**25 Clarendon Road**
**Redhill, Surrey RH1 1QZ (GB)**

(56) References cited:
**US-A1- 2007 109 716**

• **None**

## Description

## FIELD OF THE DISCLOSURE

The present disclosure relates generally to electrical components and more particularly to capacitors.

## BACKGROUND

Some capacitors are made with dielectric material sandwiched between a top and a bottom electrode in an integrated parallel-plate overlay capacitor structure. In such a structure, the bottom electrode thickness can be constrained by the dielectric thickness. The losses in the thin bottom electrodes can limit the overall high frequency quality factor of such capacitors. Additionally, the higher electrical field between the top and bottom electrodes at the edge of the crossover can create premature breakdown under the application of high bias voltages or large AC signals to the capacitor. As the frequency increases, electromagnetic waves travel towards the surface of the circuits, making the surface properties, deposition techniques and design critical. As the surface wave velocity propagates throughout the surface of the capacitor, the waves can be slowed due to the field shortening effect. The degree of the effect is typically dependent on the geometry and pattern of the top metallization.

In a standard 0603 surface mount package, the size of active area of the capacitor is just 150 micrometers square. An 0201 surface mount package would be 250 micrometers by 500 micrometers and a wire bonded package using this technology would be as small as 60 micrometers by 60 micrometers.

US 2007/0109716 A1 discloses a high Q and low stress capacitor electrode array.

## BRIEF DESCRIPTION OF THE DRAWINGS

FIG. 1 depicts an example of a stack of a thin film diamond shaped deposited electrode terminals and tunable dielectric materials on a substrate useful for understanding.
FIG. 2 depicts a micro-image of the top of two series capacitors as described in FIG. 1.
FIG. 3 depicts another example of a stack of a thin film diamond shaped deposited electrode terminals and tunable dielectric materials on a substrate useful for understanding.
FIG. 4 depicts a circuit representative of the example of FIG. 3.
FIG. 5 depicts a top view of an example of thin film diamond ring shaped electrode terminal with internal islands deposited terminals on tunable dielectric materials and a substrate useful for understanding.
FIG. 6 depicts a top view of an example of thin film terminals deposited to form a zigzag space on top of dielectric materials and a substrate useful for understanding.
FIG. 7 depicts an example of a segmented array capacitor useful for understanding.
FIG. 8 depicts a circuit representative of the example of FIG. 7.
FIG. 9 depicts an exemplary embodiment of an array capacitor utilizing non-rectangular top electrodes.
FIG. 10 depicts an example of a capacitor utilizing comb-shaped top electrodes useful for understanding.
FIG. 11 depicts an example of a nested ring capacitor useful for understanding.
FIG. 12 depicts a cross-sectional view of the capacitor of FIG. 11 taken along line A-A of FIG. 11.
FIG. 13 depicts a circuit representative of the example of FIG. 10.
FIGs. 14A-D depict other example of nested ring capacitors useful for understanding.
FIG. 15 depicts a system 1500 that can utilize one or more of the examples or the embodiments of the capacitors of FIGs. 1-14.

## DETAILED DESCRIPTION

The present disclosure describes, among other things, examples useful for understanding and illustrative embodiments of systems and methods for providing tunable capacitors, such as BST thin film capacitors, where there is reduced contact with the bottom electrodes and which creates an improved periphery with an improved quality (Q) factor and a desired aspect ratio range.

The present invention relates to a segmented capacitor in accordance with annexed claim 1.

One example of the present disclosure useful for understanding can include an apparatus having a first structure and a second structure. The first structure can include a plurality of first top electrodes, a plurality of first middle electrodes, a plurality of first bottom electrodes and a tunable dielectric medium. The tunable dielectric medium can separate the plurality of first top electrodes from the plurality of first middle electrodes to form first upper capacitors. The tunable dielectric medium can separate the plurality of first bottom electrodes from the plurality of first middle electrodes to form first lower capacitors. The first upper and lower capacitors can form a first stacked capacitor structure. The second structure can include a plurality of second top electrodes, a plurality of second middle electrodes, a plurality of second bottom electrodes and the tunable dielectric medium. The tunable dielectric medium can separate the plurality of second top electrodes from the plurality of second middle electrodes to form second upper capacitors. The tunable dielectric medium can separate the plurality of second bottom electrodes from the plurality of second middle electrodes to form second lower capacitors. The second upper and lower capacitors can form a second stacked capacitor structure. The first and second structures can share at least one electrode to provide electrical contact between the first and second structures. The plurality of first middle electrodes of the first structure can be connectable with a first bias terminal for receiving a first bias signal. The plurality of second middle electrodes of the second structure can be connectable with a second bias terminal for receiving a second bias signal.

In one or more exemplary embodiments, a capacitor is provided that comprises a substrate, a first solid electrode disposed on the substrate, and a second electrode broken into subsections. The subsections can be connected by a bus line and separated from the first electrode by a dielectric medium. The second electrode broken into subsections may have a lower resistance than the first solid electrode. By changing the width and length of the sides of the subsections, the resistance of the first electrode is modifiable.

In one or more exemplary embodiments, a BST thin film design structure is provided that optimizes electrode structure to enable very high "Q" (low resistance) capacitors through use of a process that varies the width/length aspect ratio of the electrode(s). One of the exemplary embodiments can utilize various capacitor materials where one electrode(s) is made from a higher resistance metal(s) than the opposite electrode(s). In one or more embodiments, one electrode may be thinner than the other electrode, and can exhibit a higher resistance. In one or more embodiments, capacitors with such material properties can be used in planar integrated capacitors, as well as discrete ceramic capacitors. One or more of the exemplary embodiments can reduce the mechanical stresses generated in the metals and/or dielectric films of the capacitor.

It should be understood to a person skilled in the art that "high frequency" refers to the radio spectrum between 3 MHz to 30 GHz, which includes both the "RF" spectrum and the "microwave spectrum". It shall be further understood that a "device" can include multiple "components", which can be "passive components" and/or "active components" and a "3D" device may comprise multiple layers stacked, such as vertically.

Creep is the term given to the material deformation that occurs as a result of long term exposure to levels of stress that are below the yield or ultimate strength. The rate of this damage is a function of the material properties, the exposure time, exposure temperature and the applied load (stress). Creep is usually experienced when the device is heated and cooled as a function of use or environmental temperature fluctuations. Such failures may be caused either by direct thermal loads or by electrical resistive loads, which in turn generate excessive localized thermal stresses. Depending on the magnitude of the applied stress and its duration, the deformation may become so large that it will experience brittle and/or ductile fracture, interfacial separation and creep rupture.

One or more of the exemplary embodiments can include at least one electrode structure that allows for the creation of very high "Q" (low resistance) capacitors which is well suited to common capacitor material structures where at least one electrode is made from a higher resistance metal or a thinner metal layer than the opposite electrode. High resistance electrodes can include but are not limited to Tungsten, Platinum, Rhodium, Chrome, Titanium/Tungsten, Nickel composites, and combinations thereof. Exemplary capacitors with such material properties can be utilized in planar integrated capacitors, as well as discrete ceramic capacitors. One or more of the exemplary embodiments can reduce the mechanical stresses, creep and/or other thermal generated stresses in the metals and dielectric films of the capacitor. In a broken or segmented electrode configuration of the exemplary embodiments, the broken electrode usually carries the lower resistance of the two. The broken electrode can distribute the signal across the capacitor area and, through proper arrangement, increase the effective width of the signal path through the higher resistance solid electrode. The signal busses (e.g., electrical metal connections) can be utilized for bringing in and taking out the signal. One or more of the exemplary embodiments can include at least a broken electrode and bussing, where the broken electrode can be used in various types of capacitors, and may find applicability in other components, such as transistor structures. One or more of the exemplary embodiments can realize these benefits by breaking at least two of the electrodes of a pair of series capacitors into subsections.

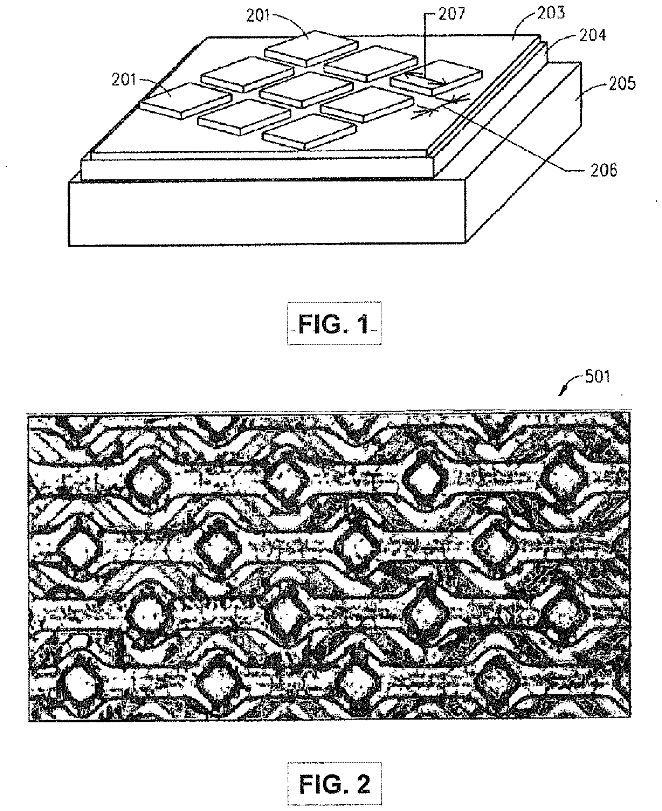

Referring to FIG. 1, a capacitor is shown having diamond-like shaped top electrode subsections 201 and a bottom electrode 204 with a substrate 205. Dielectric material 203 (e.g., a tunable dielectric such as BST material) can be sandwiched between the top and bottom electrodes 201, 204. By varying or otherwise selecting the Width (W) 207 and Length (L) 206 aspect ratio of the aperture between the electrodes in the active area, an optimized Q value can be achieved. The subsections of the top electrode 201 can be arranged to increase the effective Width 207 of the signal path in the higher resistance electrode 204. These subsections can then be electrically connected through a bus 501 as seen in the micrograph image of FIG. 2. To make a smaller more efficient capacitor, reduction of the critical dimensions 206, 207 can be maximized or otherwise improved in order to increase the active area of the capacitor. In one or more exemplary embodiments, the length (L) 206 dimension can be fixed due to lithographic constraints, therefore by modifying the (W) 207 dimension and duplicating the structure as seen in FIG. 1, the active area can be significantly increased and the change in capacitance can be increased, such as to a 5 to 1 ratio. In one exemplary embodiment, a wide frequency of tuning can be enabled, and some of the applications of the embodiments can include but are not limited to low loss phase shifters for high electronically scanning antennas.

The reduction in thermally induced creep can occur due to the individual electrode subsections retaining and creating less stress than a single plate of similar area. Shear Stress can be defined as the shear force per unit area applied to a subsection of the top electrode 201. The smaller the area of shear, the smaller the stress applied to the device. As illustrated in FIG. 1, the "diamond" configuration depicts one example useful for understanding in which the reduction of the original breaking of the electrode 201 increases the width to 4.25 times that of conventional capacitors. The reduction in resistance, leading to an increase in Q, can occur due to the length 206 of the signal path staying the same while the effective width 207 increases. The bus 501 is not shown in FIG. 1 for clarity purposes.

FIG. 1 depicts at least one apparatus and method of an example of a capacitor 3D stack useful for understanding. In one example or embodiment, a multilayer BST composite can be formed by sputter blanket PARASCAN® from Paratek Inc. (35 target) on top of a Gennum Inc. 0.2 um Pt substrate. A Gold (Au) top electrode can be patterned using conventional semiconductor lithographic techniques and sputtered on top in order to create the interconnections between the top and bottom electrodes. The example may also include at least one buffer layer. The wafer can be diced into approximate 4 of ½ by ½after the PARASCAN® deposition.

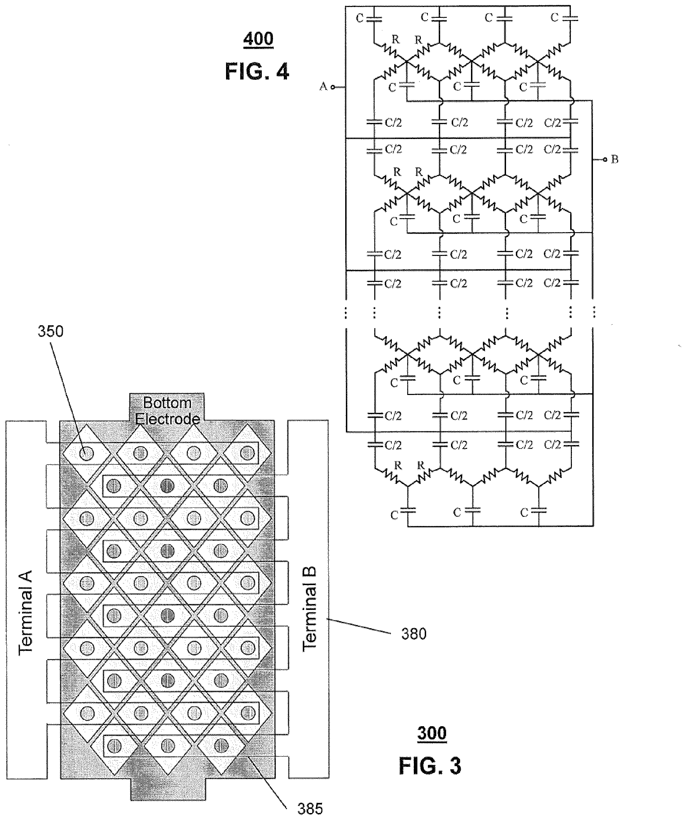

Referring to FIG. 3, another example of a capacitor 300 useful for understanding is shown. Capacitor 300, similar to the example of FIG. 1, can include diamond-shaped top electrode subsections. Terminal A and Terminal B can be connected to select top electrode subsections, such as in alternating rows. This example can increase the zero bias Q of the capacitor, which can be a voltage tunable capacitor. In this example, capacitor 300 can reduce the series resistance of the bottom electrode by increasing the periphery length around each diamond-shaped top electrode. This is done by utilizing a nested array of diamond shapes for each of the subsections of the two connected top electrodes (e.g., first top electrode connected to terminal A and second top electrode connected to terminal B). A first group of top electrodes can be connected to the RF terminal A. A second group of the top electrode subsections can be connected by interconnect metal to the RF terminal B. A bottom electrode can be utilized for the connection between the first and second groups of top electrodes. The circular areas illustrated in FIG. 3 are vias 350 used to contact the top electrodes. It should be understood that the example useful for understanding can also include other numbers of groups of top electrodes subsections. The terminals A, B can communicate input and/or output signals to the individual capacitors formed by the top and bottom electrodes. In one or more examples, the terminals A, B can have a comb shape with a terminal body 380 and a plurality of terminal fingers or connectors 385 extending therefrom, such as orthogonal from the terminal body. Circuit 400 representative of capacitor 300 is illustrated in FIG. 4 showing the configuration of the series and parallel connections of the individual capacitors formed through use of the first and second groups of top electrodes with the bottom electrode.

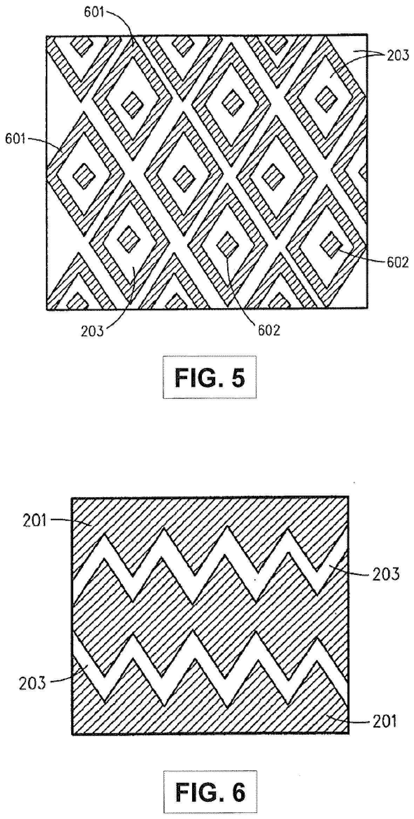

The examples useful for understanding can include the electrodes being segmented or otherwise broken into many different shapes and arranged in many different ways to create the aforementioned benefit. FIG. 5 and FIG. 6 depict capacitors without the interconnection bus 501 for clarity. The bus 501 may be patterned and deposited by one skilled in the art in order to create parallel and/or series capacitors. Two examples useful for understanding are shown in FIG. 5 and FIG. 6. These examples include at least a solid bottom electrode, where the electrodes broken into subsections in FIG. 5 can include a "diamond ring" 601 with internal "islands" 602, which can maximize or otherwise increase the (W) 207 on both sides of the top electrode. For purposes of clarity, signal bus lines 501 to connect the subsections are not depicted but would connect the islands and rings to the outside circuitry, for example through gold wire bonds or studs.

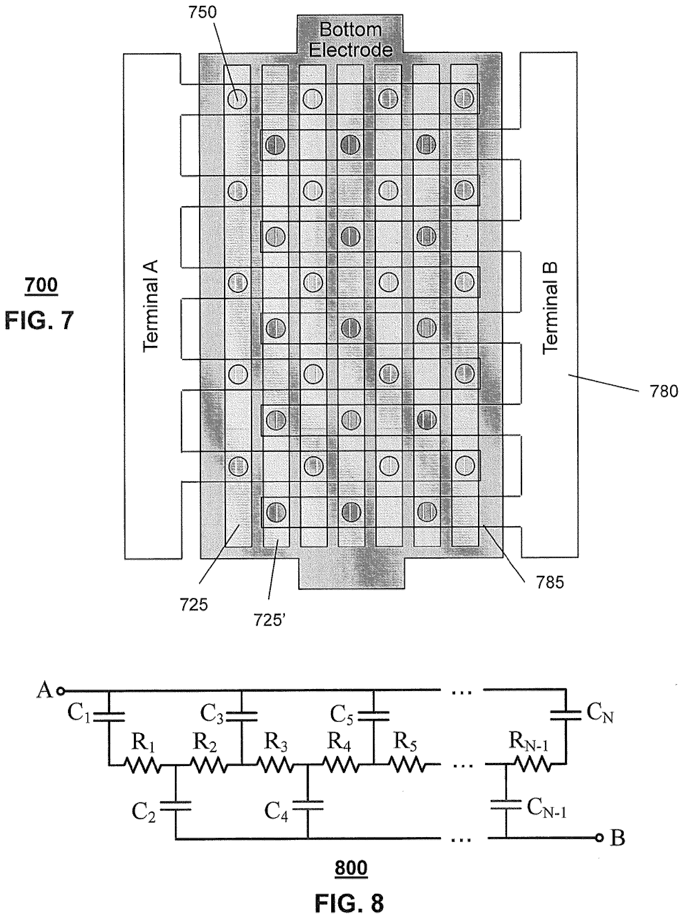

Referring to FIG. 7, a segmented capacitor 700 is illustrated which can increase the zero bias Q. Capacitor 700 can reduce the series resistance of the bottom electrode by increasing the periphery length around each top or upper electrode. One means of increasing this periphery is to segment a very wide (e.g., in the transverse direction) capacitor and place the segments next to each other as shown to make an array of top electrodes that alternate in their connection to the RF terminals A and B. The examples useful for understanding can also include the capacitors be segmented in the horizontal direction or both at once. In this example useful for understanding, surface currents in the bottom electrode can flow left and right from a given capacitor formed by way of dielectric material sandwiched with one of the rectangular top electrodes 750, thus reducing the effective resistance of this electrode by a factor of two.

A first group of the top electrodes 725 can be connected to the RF terminal A. A second group of the top electrodes 725' can be connected by interconnect metal to the RF terminal B. The first and second groups of top electrodes are formed in an alternating pattern, but the example useful for understanding can include other patterns being utilized to group the top electrodes. The bottom electrode can provide the connection between the capacitors formed by the first group of top electrodes and the capacitors formed by the second group of top electrodes. The circular areas illustrated in FIG. 7 are vias 750 used to contact the top electrodes. The terminals A, B can communicate input and/or output signals to the individual capacitors formed by the top and bottom electrodes. In one or more examples useful for understanding, the terminals A, B can have a comb shape with a terminal body 780 and a plurality of terminal fingers or connectors 785 extending therefrom, such as orthogonal from the terminal body. It should be understood that the examples useful for understanding can also include other numbers of groups of top electrodes subsections. Circuit 800 representative of capacitor 700 is illustrated in FIG. 8 showing the configuration of the series and parallel connections of the individual capacitors formed through use of the first and second groups of top electrodes with the bottom electrode.

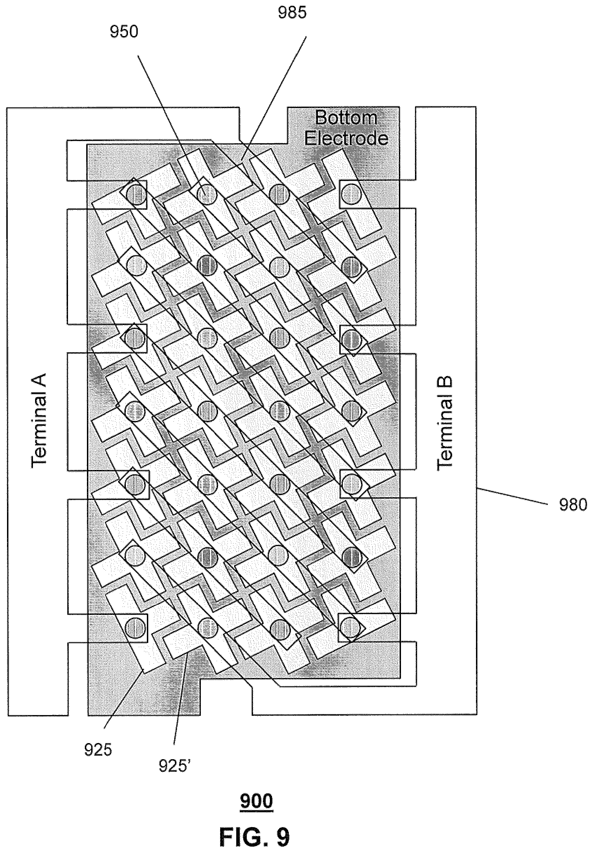

Referring to FIG. 9, a segmented capacitor 900 is illustrated which can increase the zero bias Q. Capacitor 900 can reduce the series resistance of the bottom electrode by increasing the periphery length around each top or upper electrode. One means of increasing this periphery is use a nested array of crosses for the two top electrodes (e.g., a first group of cross-shaped electrodes 925 connected to terminal A and a second group of cross-shaped electrodes 925' connected to terminal B). The first and second groups of top electrodes are formed in an alternating pattern, but the exemplary embodiment can include other patterns being utilized to group the top electrodes. The bottom electrode can provide the connection between the capacitors formed by the first group of top electrodes and the capacitors formed by the second group of top electrodes. The circular areas illustrated in FIG. 9 are vias 950 used to contact the top electrodes. It should be understood that the exemplary embodiments can also include other numbers of groups of top electrodes subsections. Capacitor 900 can provide for series and parallel connections of the individual capacitors formed through use of the first and second groups of top electrodes with the bottom electrode. The terminals A, B can communicate input and/or output signals to the individual capacitors formed by the top and bottom electrodes. In one or more embodiments, the terminals A, B can have a terminal body 980 and a plurality of terminal fingers or connectors 985 extending therefrom. In one or more embodiments, a portion of one or more of the terminal connectors 985 can be orthogonal to the terminal body 980. In one or more embodiments, all or a portion of the terminal connectors 985 can be non-orthogonal to the terminal body 980 to facilitate connecting each of the first and second groups of top electrodes 925, 925' with terminals A, B, respectively.

In one or more embodiments, Capacitor 900 can utilize the cross-shaped top electrodes 925, 925' so as to maintain a consistent gap between each of the adjacent electrodes and/or maintain symmetry of the electrode subsection pattern. Other shapes can also be utilized for the crosses 925, 925' including other non-rectangular shapes. In one embodiment a combination of shapes can be utilized such as the crosses and half-crosses depicted in FIG. 9. In one embodiment, the non-rectangular shapes used for the top electrode subsections can provide for an electrode subsections having at least one edge that is parallel with another edge of an adjacent top electrode subsection.

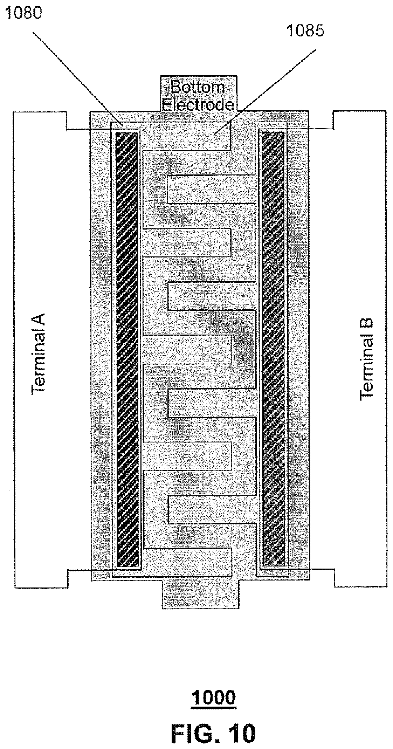

Referring to FIG. 10, a capacitor 1000 is illustrated which can increase the zero bias Q. Capacitor 1000 can reduce the series resistance of the bottom electrode by increasing the periphery length around each top or upper electrode. One means of increasing this periphery is to use a comb-shaped upper electrode pattern comprising a first comb-shaped electrode 1025 and a second-comb shaped electrode 1025'. The bottom electrode can provide the connection between the capacitors formed from the first and second comb-shaped top electrodes 1025, 1025'. In one or more examples useful for understanding, the comb-shaped electrodes 1025, 1025' can include an electrode body 1080 and a plurality of electrode fingers or connectors 1085 extending therefrom, such as orthogonal from the electrode body. The terminals A, B can communicate input and/or output signals to the individual capacitors formed by the top and bottom electrodes. In one example useful for understanding, the terminals A, B can be connected with the electrodes 1025, 1025" along or in proximity to the corresponding electrode bodies 1080. It should be understood that the example useful for understanding can also include other numbers of groups of top electrodes subsections. In one or more examples useful for understanding, capacitor 1000 can utilize the first and second comb-shaped electrodes 1025, 1025' including the orthogonal electrode fingers or connectors 1085 so as to maintain a consistent gap between each of the two top electrodes.

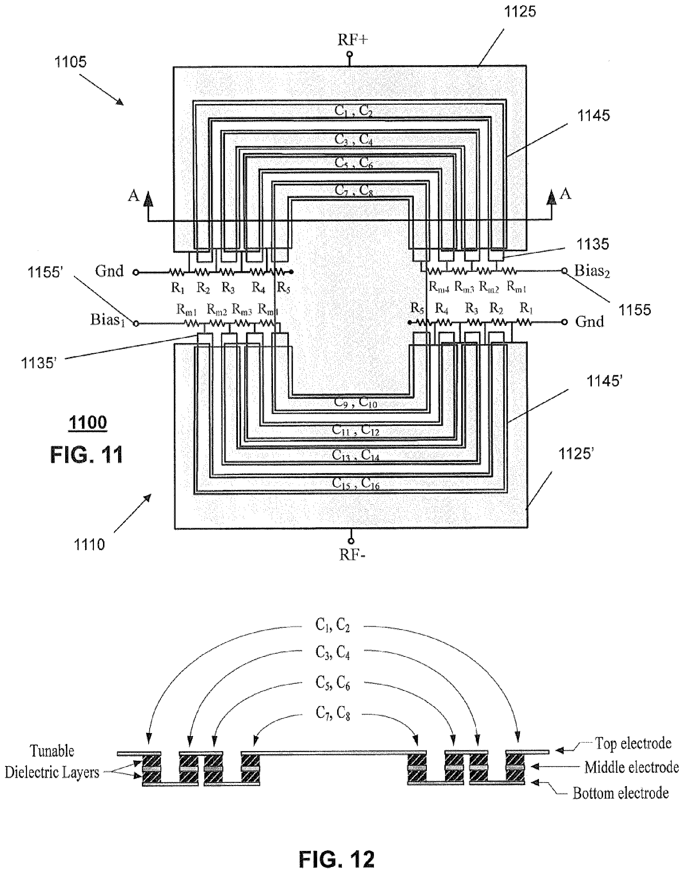

Referring to FIGs. 11 and 12, a capacitor 1100 is illustrated having a nested ring configuration. Capacitor 1100 can include a first capacitor portion or structure 1105 and a second capacitor portion or structure 1110. In one example useful for understanding, the first and second capacitors portions can be symmetrical. First capacitor portion 1105 can include top electrodes 1125, middle electrodes 1135, bottom electrodes 1145, and biasing terminal 1155. A dielectric medium(s) 1165 (e.g., a tunable dielectric such as a BST material) can be used to separate the top, middle and bottom electrodes 1125, 1135, 1145 of the first capacitor portion 1105. Second capacitor portion 1110 can include top electrodes 1125', middle electrodes 1135', bottom electrodes 1145', and biasing terminal 1155'. A dielectric medium(s) (e.g., a tunable dielectric such as a BST material) can be used to separate the top, middle and bottom electrodes 1125', 1135', 1145' of the second capacitor portion 111.

Capacitor 1100 can increase the perimeter length of middle electrodes 1135, 1135' without increasing the area of the electrodes. In one example useful for understanding, the broken concentric ring-like structure of capacitor 1100 can be used to enable a graded value of capacitance where the outer rings are higher capacitance values and the inner rings have lower capacitance values. With the appropriate resistive bias network, this arrangement of capacitors can permit lower time constants compared to a uniform distribution of capacitor values.

Capacitor 1100 is illustrated as a dual layer capacitor, meaning that two capacitors are stacked vertically to make each ring. However, the examples useful for understanding can include single layer or multiple layers with more than two stacked layers that utilize all or a portion of the features of capacitor 1100. Cross section A-A illustrates the construction of the capacitors as stacked capacitors using three metal layers.

It should be understood that each metal layer shown here may be a combination of metals. For instance, Pt may be used to contact the tunable dielectric layers (e.g., PARASCAN®) and/or TiW may be used next to the Pt for adhesion purposes. Other metals with higher electrical or thermal conductivity may be employed to lower the electrical and/or thermal resistance of each electrode.

Capacitor 1100 can provide a symmetrical biasing network. Capacitor 1100 can achieve low charging times or low time constants for all capacitors in the string. Capacitor 1100 is in essence a splitting of the bias network into two halves, which may be symmetric as shown (or in one or more examples useful for understanding may be asymmetrical), to enable charging current to be injected equally along both sides of the capacitor string. To facilitate equalizing the charging times so as to achieve the shortest overall transient response, the capacitor values can be graded in the following manner such that the largest capacitors are found near the ends of the string:

$$C_1 \cong C_2 > C_3 \cong C_4 > C_5 \cong C_6 > C_7 \cong C_8$$

$$C_9 \cong C_{10} < C_{11} \cong C_{12} < C_{13} \cong C_{14} < C_{15} \cong C_{16}$$

In one or more examples useful for understanding, the bias resistors $R_m$ may be graded so as to have the largest resistor near the bias terminals:

$$R_{m1} > R_{m2} > R_{m3} > R_{m4}$$

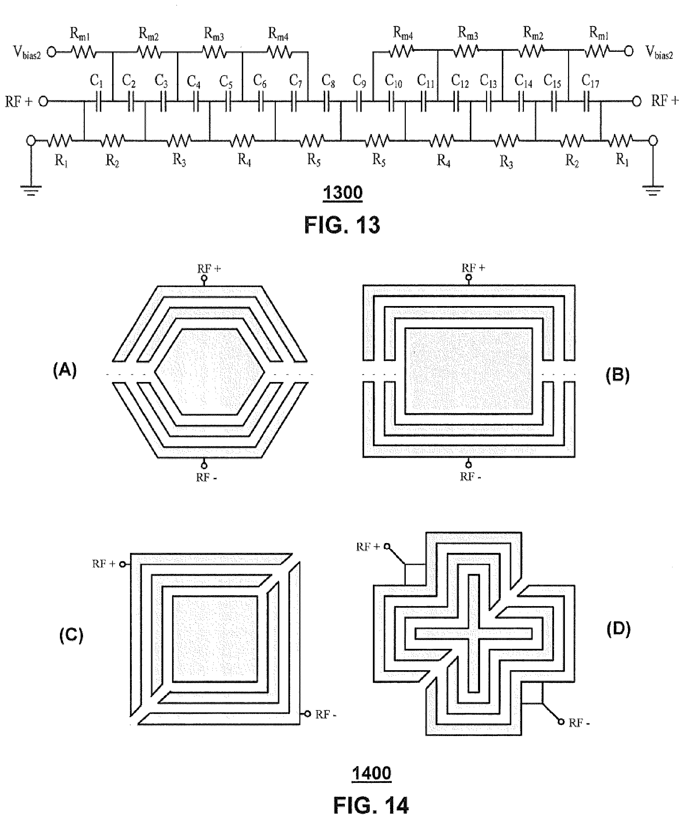

This bias resistor grading can also be done to facilitate equalizing the charging times across capacitors in the string. Circuit 1300 representative of capacitor 1100 is illustrated in FIG. 13. Additionally, while the example of FIG. 11 describes two bias terminals, it is also contemplated that any number of bias terminals can be utilized such as a single bias terminal or three or more bias terminals. The nested configuration can be adjusted based on the number of biasing terminals. Additionally, any number of capacitor portions can be utilized, including using four portions with four bias terminals, where the four portions can share a center top electrode.

One or more examples useful for understanding can utilize the nested ring capacitor configuration of FIG. 11, but with different shapes for the electrodes. Referring to FIGs, 14A-14D, the four capacitor designs represent top electrode metal patterns built as nested rings. The examples useful for understanding can include other polygonal shapes which may or may not provide a symmetrical configuration. Bias resistors are omitted for clarity in FIGs. 14A-14D, but they can be located in the vicinity of the gaps in the outer rings.

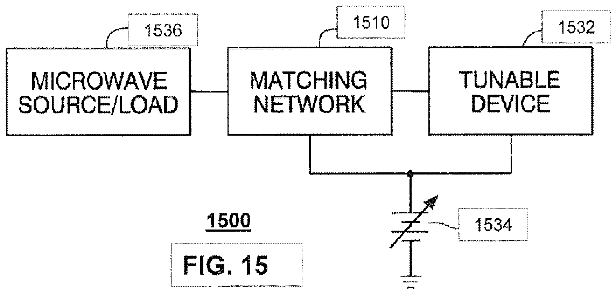

FIG. 15 is a block diagram of a system 1500 having a matching network 1510 that can utilize one or more of the exemplary capacitors or other components described herein. The matching network 1510 can be coupled to a tunable microwave device 1532. The tunable microwave device 1532 could be one of many devices which have varying input/output characteristic impedances such as tunable phase shifters, delay lines, filters, etc. In one example useful for understanding, the adjustable external DC voltage source 1534 can be used to supply bias voltage to the matching network 1510 and the tunable microwave device 1532 in tandem. As the voltage supplied by the external DC voltage source 1534 changes, the characteristic input/output impedance of the tunable dielectric device may also change. At the same time, the impedance characteristics of the matching network 1510 can change to maximize, improve or otherwise adjust power transfer from/to the microwave source/load 1536 to/from the tunable microwave device 1532. In one example useful for understanding, the tunable microwave device 1532 and the matching network 1510 can be controlled by two different external DC voltage sources. The examples useful for understanding can be utilized in other circuits that may or may not include matching networks.

In one exemplary method, an electrode can be broken into subsections with signal bus lines connecting the subsections and a solid electrode to improve Q. The method may further comprise distributing the signal across the capacitor area by the broken electrode and thereby increasing the effective width of a signal path through the solid electrode. The capacitor may be of various forms including a planar integrated capacitor or a discrete ceramic capacitor. The method may still further comprise adapting the solid electrode and the broken electrode to reduce the mechanical stresses generated in the metals and dielectric films of the capacitor. For example, the capacitor can be utilized in a pair of series capacitors where the subsections are arranged in such a manner that it increases the effective width of the signal path in the solid electrode. In one example useful for understanding, a series network of voltage tunable dielectric capacitors can be provided, such as according to the steps and structures described herein, which are all, or a portion thereof, tuned using a common tuning voltage.

In one examples or embodiment, a capacitor electrode structure is provided that allows for the creation of very high "Q" (e.g., low resistance) capacitors. For instance, one electrode can be made from a higher resistance metal than the opposite electrode, such as in planar integrated capacitors, as well as discrete ceramic capacitors. As an example, the electrodes can be broken into subsections, with signal bus lines connected to the subsections and/or to a solid electrode. The broken electrode preferably has the lower resistance material of the two. The broken electrode may distribute the signal across the capacitor area and, through proper arrangement, increase the effective width of the signal path through the higher resistance solid electrode. The signal busses may bring in and take out the signal. Voltage tunable dielectric material can be utilized between the electrodes.

One or more of the examples or embodiments can include a first or bottom electrode(s), such as platinum, patterned and deposited into a substrate. A dielectric material, such as a thin film coating of a BST type material can be deposited on top of the bottom electrode, such as according to one or more of the exemplary configurations described above. A top or second electrode(s) can be deposited on top of the BST film.

Interconnects, vias and the like can be utilized with the examples or the embodiments, including being deposited over a portion of the thin film structure, to provide attachment to other components, such as a microwave circuit and/or to provide an electrical path to at least one of the electrodes. Various materials including gold, aluminum and silver can be provided using various techniques including sputter and depositing to form some of the components of one or more of the examples or the embodiments, such as the electrode(s), the bus and so forth. In one example or embodiment, a polymer encapsulation can be deposited to provide protection from ambient conditions and/or as a humidity barrier. In one example or embodiment, multiple layers of dielectric materials (e.g., BST thin films) and/or electrodes can be deposited or otherwise formed to create an elaborate 3D structure of a multiple layer capacitor stack.

One or more of the examples or the embodiments of the capacitor configurations can be utilized in various systems. For instance, wireless communications is a rapidly growing segment of the communications industry, with the potential to provide high-speed high-quality information exchange between portable devices located anywhere in the world. Potential applications enabled by one or more of the examples or the embodiments include multimedia internet-enabled cell phones, smart homes, appliances, automated highway systems, distance learning, and autonomous sensor networks, just to name a few.

One or more of the examples or the embodiments can be used to enable low loss devices that can be used at higher frequency ranges. One or more of the examples or the embodiments can utilize relatively low capacitance varactors that can operate at temperatures above those necessary for superconduction and at bias voltages less than those required for existing planar varactor structures, while maintaining high tunability and high Q factors. Even though these materials may work in their paraelectric phase above the Curie temperature, they are conveniently called "ferroelectric" because they exhibit spontaneous polarization at temperatures below the Curie temperature. Tunable ferroelectric materials including barium-strontium titanate $Ba_xSr_{1-x}TiO_3$ (BST) or BST composites have been the subject of several patents. Dielectric materials including BST are disclosed by Sengupta, et al. in U.S. Pat. No. 5,312,790; U.S. Pat. No. 5,427,988; U.S. Pat. No. 5,486,491; U.S. Pat. No. 5,846,893; U.S. Pat. No. 5,635,434; U.S. Pat. No. 5,830,591; U.S. Pat. No. 5,766,697; U.S. Pat. No. 5,693,429; U.S. Pat. No. 6,074,971; U.S. Pat. No. 6,801,104 B2 and U.S. Pat. No. 5,635,433. The dielectric constant of these materials can be varied by varying the strength of an electric field to which the materials are subjected. These materials allow for thin-film ferroelectric composites of low overall dielectric constant that takes advantage of the high tunability and at the same time having high dielectric constants. BST thin films can be used with one or more of the examples or the embodiments due to their high dielectric constant, high tunability, low loss, and fast switching speed.

One or more of the examples or the embodiments can include the use of non-tunable dielectric material alone or in combination with other capacitors that utilize tunable dielectric material. The configuration of tunable and non-tunable capacitors formed by the examples or the embodiments can vary. The examples or the embodiments can also include the use of different dielectric materials by different individual capacitors formed by the segmented electrodes and the solid electrode, including a plurality of different tunable dielectric materials and/or a plurality of non-tunable dielectric materials forming individual capacitors that are in parallel and/or series and with each other.

Quality factor, resonance frequency and breakdown voltage can be important factors for determining when thin film capacitor can be utilized. High-frequency device losses consist of material-related losses in the film and at the electrode-film interface, as well as the resistive losses in the electrodes. Thermal strain can occur on the interface between the ferroelectric thin film and the metal electrode due to the creation of oxide films and crystalline microstructure. This interface is generally the cause of losses at high frequencies and premature breakdown at low voltages. Also, the designs on current devices are limited by traditional design guidelines that create resistive losses due to design constraints.

The illustrations of examples and embodiments described herein are intended to provide a general understanding of the structure of various examples and embodiments, and they are not intended to serve as a complete description of all the elements and features of apparatus and systems that might make use of the structures described herein. Many other examples and embodiments will be apparent to those of skill in the art upon reviewing the above description. Figures are also merely representational and may not be drawn to scale. Certain proportions thereof may be exaggerated, while others may be minimized.

The Abstract of the Disclosure is provided with the understanding that it will not be used to interpret or limit the scope or meaning of the claims. In addition, in the foregoing Detailed Description, it can be seen that various features are grouped together in a single embodiment for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus the following claims are hereby incorporated into the Detailed Description, with each claim standing on its own as a separately claimed subject matter.

**Claims**

1. A segmented capacitor (900), comprising:

   a first solid electrode (204);
   a second electrode (201) separated into subsections (925, 925'); and
   a dielectric medium (203) separating the subsections (925, 925') from the first solid electrode (204),
   wherein the subsections (925, 925') of the second electrode (201) comprise a first group of subsections (925) and a second group of subsections (925'),
   wherein the first group of subsections (925) is connectable with a first terminal (A) for receiving an input signal, and
   wherein the second group of subsections (925') is connectable with a second terminal (B) for providing an output signal,
   **characterised in that** the first group of subsections (925) and the second group of subsections (925') form a nested array of crosses.

2. The segmented capacitor (900) of claim 1, wherein the first group of subsections (925) and the first solid electrode (204) form a first group of capacitors,

   wherein the second group of subsections (925') and the first solid electrode (204) form a second group of capacitors,
   wherein each capacitor of the first group of capacitors is electrically connected in parallel,
   wherein each capacitor of the second group of capacitors is electrically connected in parallel, and
   wherein the first group of capacitors is electrically connected in series with the second group of capacitors.

3. The segmented capacitor (900) of any preceding claim, wherein the first and second terminals (A, B) have a comb shape with a terminal body (980) and terminal connectors (985) extending from the terminal body (980), and wherein the terminal connector (985) of the first terminal (A) and the terminal connector (985) of the second terminal (B) are connected with the first group of subsections (925) and the second group of subsections (925') of the second electrode (201), respectively, using metal vias (950).

4. The segmented capacitor (900) of claim 3, wherein at least a portion of the terminal connectors (985) is non-orthogonal to the terminal body (980).

5. The segmented capacitor (900) of any preceding claim, wherein the second electrode (201) separated into the subsections (925, 925') has a lower resistance than the first solid electrode (204).

6. The segmented capacitor (900) of any preceding claim, wherein the first group of subsections (925) and the first solid electrode (204) form a first group of capacitors, wherein the second group of subsections (925') and the first solid electrode (204) form a second group of capacitors, and wherein the first and second groups of capacitors are formed in an alternating pattern.

7. The segmented capacitor (900) of any preceding claim, wherein the first and second terminals (A, B) have a comb shape with a terminal body (980) and terminal connectors (985) extending from the terminal body (980).

8. The segmented capacitor (900) of any preceding claim, wherein the dielectric medium is a tunable dielectric medium comprising barium-strontium titanate.

9. The segmented capacitor (900) of any preceding claim, wherein each adjacent subsection (925, 925') is separated by an equal gap.

**Patentansprüche**

1. Segmentierter Kondensator (900), umfassend:

   eine erste Festelektrode (204);
   eine in Unterabschnitte (925, 925') aufgetrennte zweite Elektrode (201); und
   ein dielektrisches Medium (203), das die Unterabschnitte (925, 925') von der ersten Festelektrode (204) trennt,
   wobei die Unterabschnitte (925, 925') der zweiten Elektrode (201) eine erste Gruppe von Unterabschnitten (925) und eine zweite Gruppe von Unterabschnitten (925') umfassen,
   wobei die erste Gruppe von Unterabschnitten (925) mit einem ersten Anschluss (A) zum Empfangen eines Eingangssignals verbindbar ist und
   wobei die zweite Gruppe von Unterabschnitten (925') mit einem zweiten Anschluss (B) zum Bereitstellen eines Ausgangssignals verbindbar ist,

**dadurch gekennzeichnet, dass** die erste Gruppe von Unterabschnitten (925) und die zweite Gruppe von Unterabschnitten (925') ein vernestetes Array von Kreuzen bilden.

2. Segmentierter Kondensator (900), wobei die erste Gruppe von Unterabschnitten (925) und die erste Festelektrode (204) eine erste Gruppe von Kondensatoren bilden,

wobei die zweite Gruppe von Unterabschnitten (925') und die erste Festelektrode (204) eine zweite Gruppe von Kondensatoren bilden, wobei jeder Kondensator der ersten Gruppe von Kondensatoren elektrisch parallel geschaltet ist, wobei jeder Kondensator der zweiten Gruppe von Kondensatoren elektrisch parallel geschaltet ist und wobei die erste Gruppe von Kondensatoren mit der zweiten Gruppe von Kondensatoren elektrisch in Reihe geschaltet ist.

3. Segmentierter Kondensator (900) nach einem der vorhergehenden Ansprüche, wobei der erste und zweite Anschluss (A, B) eine Kammform mit einem Anschlusskörper (980) und sich von dem Anschlusskörper (980) erstreckenden Anschlussverbindern (985) aufweisen und wobei der Anschlussverbinder (985) des ersten Anschlusses (A) und der Anschlussverbinder (985) des zweiten Anschlusses (B) unter Verwendung von Metalldurchkontaktierungen (950) mit der ersten Gruppe von Unterabschnitten (925) bzw. der zweiten Gruppe von Unterabschnitten (925') der zweiten Elektrode (201) verbunden sind.

4. Segmentierter Kondensator (900) nach Anspruch 3, wobei mindestens ein Teil der Anschlussverbinder (985) zu dem Anschlusskörper (980) nicht orthogonal ist.

5. Segmentierter Kondensator (900) nach einem der vorhergehenden Ansprüche, wobei die in die Unterabschnitte (925, 925') aufgetrennte zweite Elektrode (201) einen niedrigeren Widerstand als die erste Festelektrode (204) aufweist.

6. Segmentierter Kondensator (900) nach einem der vorhergehenden Ansprüche, wobei die erste Gruppe von Unterabschnitten (925) und die erste Festelektrode (204) eine erste Gruppe von Kondensatoren bilden, wobei die zweite Gruppe von Unterabschnitten (925') und die erste Festelektrode (204) eine zweite Gruppe von Kondensatoren bilden und wobei die erste und zweite Gruppe von Kondensatoren in einem alternierenden Muster gebildet sind.

7. Segmentierter Kondensator (900) nach einem der vorhergehenden Ansprüche, wobei der erste und zweite Anschluss (A, B) eine Kammform mit einem Anschlusskörper (980) und sich von dem Anschlusskörper (980) erstreckenden Anschlussverbindern (985) aufweisen.

8. Segmentierter Kondensator (900) nach einem der vorhergehenden Ansprüche, wobei das dielektrische Medium ein abstimmbares dielektrisches Medium ist, das Barium-Strontium-Titanat umfasst.

9. Segmentierter Kondensator (900) nach einem der vorhergehenden Ansprüche, wobei jeder angrenzende Unterabschnitt (925, 925') durch eine gleiche Lücke getrennt wird.

**Revendications**

1. Condensateur segmenté (900), comprenant :

une première électrode solide (204) ; une seconde électrode (201) séparée en sous-sections (925, 925') ; et un milieu diélectrique (203) séparant les sous-sections (925, 925') de la première électrode solide (204), dans laquelle les sous-sections (925, 925') de la seconde électrode (201) comprennent un premier groupe de sous-sections (925) et un second groupe de sous-sections (925'), dans lequel le premier groupe de sous-sections (925) peut être connecté à une première borne (A) pour recevoir un signal d'entrée, et dans lequel le second groupe de sous-sections (925') peut être connecté à une seconde borne (B) pour fournir un signal de sortie, **caractérisé en ce que** le premier groupe de sous-sections (925) et le second groupe de sous-sections (925') forment un réseau imbriqué de croix.

2. Condensateur segmenté (900) selon la revendication 1, dans lequel le premier groupe de sous-sections (925) et la première électrode solide (204) forment un premier groupe de condensateurs,

dans lequel le second groupe de sous-sections (925') et la première électrode solide (204) forment un second groupe de condensateurs, dans lequel les condensateurs du premier groupe de condensateurs sont connectés électriquement en parallèle, dans lequel les condensateurs du second groupe de condensateurs sont connectés électriquement en parallèle, et dans lequel le premier groupe de condensateurs est connecté électriquement en série avec le second groupe de condensateurs.

3. Condensateur segmenté (900) selon l'une quelconque des revendications précédentes, dans lequel les première et seconde bornes (A, B) ont une forme de peigne avec un corps de borne (980) et des connecteurs de borne (985) s'étendant à partir du corps de borne (980), et dans lequel le connecteur de borne (985) de la première borne (A) et le connecteur de borne (985) de la seconde borne (B) sont connectés au premier groupe de sous-sections (925) et au second groupe de sous-sections (925') de la seconde électrode (201), respectivement, au moyen de trous d'interconnexion métalliques (950).

4. Condensateur segmenté {900) selon la revendication 3, dans lequel au moins une partie des connecteurs de borne (985) est non orthogonale au corps de borne (980).

5. Condensateur segmenté (900) selon l'une quelconque des revendications précédentes, dans lequel la seconde électrode (201) séparée en les sous-sections (925, 925') présente une résistance inférieure à celle de la première électrode solide (204).

6. Condensateur segmenté (900) selon l'une quelconque des revendications précédentes, dans lequel le premier groupe de sous-sections (925) et la première électrode solide {204) forment un premier groupe de condensateurs, le second groupe de sous-sections (925') et la première électrode solide (204) forment un second groupe de condensateurs, et les premier et second groupes de condensateurs sont formés selon un motif alterné.

7. Condensateur segmenté (900) selon l'une quelconque des revendications précédentes, dans lequel les première et seconde bornes (A, B) présentent une forme de peigne avec un corps de borne (980) et des connecteurs de borne (985) s'étendant à partir du corps de borne (980).

8. Condensateur segmenté (900) selon l'une quelconque des revendications précédentes, dans lequel le milieu diélectrique est un milieu diélectrique accordable comprenant du titanate de baryum-strontium.

9. Condensateur segmenté (900) selon n'importe quelle revendication précédente, dans lequel chaque sous-section adjacente (925, 925') est séparée par un même espace.

**FIG. 1**

**FIG. 2**

**400**

**FIG. 4**

**300**

**FIG. 3**

601

203

601

602

203          602

**FIG. 5**

201

203

203

201

**FIG. 6**

**700**
**FIG. 7**

**800**
**FIG. 8**

**FIG. 9**

**900**

**1000**

## FIG. 10

**1100**
**FIG. 11**

**FIG. 12**

1300

**FIG. 13**

(A)

(B)

(C)

(D)

1400

**FIG. 14**

1536

1510

1532

MICROWAVE
SOURCE/LOAD

MATCHING
NETWORK

TUNABLE
DEVICE

1500

FIG. 15

1534

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20070109716 A1
- US 5312790 A
- US 5427988 A
- US 5486491 A
- US 5846893 A
- US 5635434 A
- US 5830591 A
- US 5766697 A
- US 5693429 A
- US 6074971 A
- US 6801104 B2
- US 5635433 A